# EUROPEAN PATENT APPLICATION

(11) **EP 2 151 693 A1**
(43) Date of publication of application: **10.02.2010**
(21) Application number: 08775390.1
(22) Date of filing: 23.05.2008
(51) Int. Cl.: G01R 27/26, H03B 1/00

(54) **CAPACITANCE-TO-FREQUENCY CONVERTER CIRCUIT FOR CAPACITIVE TRANSDUCERS**

(30) Priority: 31.05.2007 ES 200701489
(71) Applicant: Farsens, S.L., 20009 San Sebastián Guipuzcoa (ES)
(72) Inventor: BERENGUER PÉREZ, Roc, E-20010 San Sebastián (Guipuzcoa) (ES); SEVILLANO BERASATEGUI, Juan Francisco, E-20014 San Sebastián (Guipuzcoa) (ES); GARCÍA-ALONSO MONTOYA, Andrés, E-20009 San Sebastián (Guipuzcoa) (ES); AYERDI OLAIZOLA, Isabel, E-20003 Donostia (Guipuzcoa) (ES); VÉLEZ ISASMENDI, Igone, E-20014 San Sebastián (Guipuzcoa) (ES); GUTIÉRREZ GARCÍA, Iñigo, E-20011 San Sebastián (Guipuzcoa) (ES); UBARRETXENA BELANDIA, Aritz, E-20003 San Sebastián (Guipuzcoa) (ES); VALDERAS GÁSQUEZ, Daniel, E-20010 San Sebastián (Guipuzcoa) (ES); NIETO FERNÁNDEZ, F. Javier, E-20100 Renteria (Guipuzcoa) (ES); GIL-NEGRETE LABORDA, Nere, E-20011 San Sebastián (Guipuzcoa) (ES); AGUIRREURRETA GARIN, Ana, E-20700 Zumarraga (Guipuzcoa) (ES); VAZ SERRANO, Alexander, E-20010 San Sebastián (Guipuzcoa) (ES); PARDO SÁNCHEZ, Daniel, E-20009 San Sebastián (Guipuzcoa) (ES); ZALBIDE AGIRREZABALAGA, Ibon, E-20011 San Sebastián (Guipuzcoa) (ES); MAYORDOMO LASTRA, Iker, E-48950 Astrabudua-Erandio (Vizcaya) (ES); GÓMEZ URDANPILLETA, José Antonio, E-20160 Lasarte-Oria (Guipuzcoa) (ES); YANGUAS AMATRIAIN, Maite, E-20301 Irún (Guipuzcoa) (ES); MERINO GUEVARA, Amaia, E-20280 Hondarribia (Guipuzcoa) (ES)
(74) Representative: Cabinet Plasseraud
(86) International application number: PCT/ES2008/000362
(87) International publication number: WO 2008/145783

(57) **Abstract**

The invention relates to a capacity-frequency converter circuit for capacitive transducers formed by a ring oscillator (2000) including variable capacity capacitors with a capacity that can vary with the magnitude to be measured, a binary counter (3000) providing a binary digital output, a parallel-to-serial converter (40000) and a control logic block (1000) coordinating the operations between the mentioned components.

## Description

### Field of the Art

The present invention relates to the devices which are known as capacitive transducers, proposing a capacity-frequency converter circuit, with digital output, for said devices.

### State of the Art

There is currently a clear trend to minimize the power consumption of integrated circuits, this trend originating in the wide growth of those applications in which the power consumption is crucial, such as in, for example, wireless sensors, RFID (Radio Frequency Identification) transponders provided with a sensor, etc.

Circuits consisting of a battery with a very limited power availability (active circuits) and circuits which collect and temporarily store the power of a radiating source for their correct operation (passive circuits) can be distinguished in such applications, being desirable to reach minimum power consumption levels in both types of circuits.

In addition, in most current applications, and especially in those relating to capacitive transducers, it is preferable to have the output information of the circuit in digital (rather than analog) form, even though it involves a certain increase in the total consumption of the circuit.

In this sense, patent ES 200600518 describes a capacitive transducer able to convert the value of the magnitude to be measured into the analog width of an output pulse, said transducer comprising two chains of inverters with inserted capacitors and a logic gate producing the pulse the width of which is a function of the magnitude to be measured, such that one of the chains consists of fixed capacity capacitors (which do not vary with the magnitude to be measured), generating a constant delay for any value of the magnitude, while the other chain consists of variable capacitors generating a variable delay that varies with the value of the magnitude to be measured, such that the outputs of both chains are combined in the logic gate, giving as a result in its output a pulse the temporal width of which is the difference between both delays. A pulse the width of which is a function of the magnitude to be measured is thus provided as analog output of the transducer.

Said solution has a drawback due to the analog nature of the pulse obtained at the output, since in order to obtain a digital representation of the value of the measured magnitude it is necessary to digitalize the temporal width of the output pulse delivered by the logic gate, making a second converter block for converting the duration of the pulse into digital necessary, thus considerably increasing the total consumption of the circuit.

Patent document PCT/ES2006/000562 in turn describes a temperature sensor based on a ring oscillator, in which the temperature is measured through the thermal dependence of the delay introduced by the inverters of the ring oscillator, such that the pulses delivered by the oscillator are counted in a counter, a digital representation of the temperature measurement being obtained. However, this invention does not contemplate measuring any magnitude other than temperature, nor does it use external capacitors of any type.

### Object of the Invention

According to the invention, a capacity-frequency converter circuit is proposed with which a low consumption is obtained, allowing the application in sensors that can be incorporated in RFID transponders and generally in wireless sensors.

This circuit object of the invention consists of a ring oscillator, which generates a pulse train the frequency of which is dependent on the delay introduced by the logic gates and by the variable capacitors forming it, and in turn, the capacity of said capacitors and therefore the delay and the frequency of the pulse train, vary with the magnitude to be measured, as is characteristic of capacitive transducers; a binary counter counting the number of pulses delivered by the oscillator in a given time extracted from a clock signal; and optionally a parallel-to-serial digital converter, which takes the parallel digital representation of the measurement given by the binary counter and converts it into another serial digital representation; a control logic block furthermore being incorporable to coordinate the operations of the previous modules; and for calibration, a register or memory (volatile or nonvolatile), where the digital representation of the measurement is stored.

The ring oscillator is made up of an odd number of negation logic gates, which generate oscillation; an activation/deactivation circuit for activating/deactivating the supply voltage for the rest of the components of the oscillator; a current source with a high power supply rejection ratio (PSRR) to supply the logic gates generating oscillation; a start-up circuit to establish the stable operating point of the current source; and one or several variable capacitors inserted between the negation logic gates, making the frequency of the pulse train vary with the magnitude to be measured.

The binary counter counts the number of pulses of the pulse train delivered by the oscillator in a certain time, whereby a binary digital representation of the measurement is obtained (given, for example, by a 12-bit word in parallel). To that end, as a possible embodiment, the counter is formed, for example, by type D flip-flops, type D latches and inverter logic gates.

The parallel-to-serial converter (optional) takes the digital word delivered in parallel by the counter, and converts it into a serial digital word, for which purpose, as a possible embodiment, the converter is formed by type D flip-flops, inverter logic gates, AND logic gates and OR logic gates; the serial digital word being able to be stored in a register or memory, for its subsequent sending or for its use in calibration.

Finally, the control logic block takes the two signals entering the circuit (the clock signal and the start-up signal of the measurement), generating three signals which are necessary for the correct coordination between the different modules of the circuit, such that the first of said signals establishes the time necessary for carrying out the measurement until the parallel representation is delivered at the output of the counter, the second signal controls the start and end of the operation of the ring oscillator, and the third signal defines the time during which the pulses delivered by the oscillator are counted in the counter. To that end, as a possible embodiment, the control logic block consists of several sub-blocks, which in turn are formed by type D flip-flops, inverter logic gates, AND logic gates, OR logic gates and NOR logic gates.

In relation to the calibration of the capacitive transducer, a relative measurement is carried out for a reference value of the magnitude object of the measure (which involves a capacity reference value on the part of the capacitors), and the corresponding digital representation is stored in the register or memory, for its possible sending, as a reference value, to a monitor (reader or receiver).

### Description of the Drawings

Figure 1 shows a general block diagram of the circuit of the invention.
Figure 2 depicts the block diagram of the upper hierarchical level of the control logic of said circuit of the invention.
Figure 3 depicts a block diagram of a following hierarchical level of the mentioned control logic of the circuit.
Figure 4 is a block diagram of another hierarchical level of the control logic of the circuit.
Figure 5 depicts a block diagram of the block T_Start of the previous figure.
Figure 6 depicts a block diagram of the block Osc_Start of Figure 4.
Figure 7 depicts a block diagram of the block Meas & Enable of Figure 3.
Figure 8 shows the block diagram of the upper hierarchical level of the oscillator of the circuit of the invention.
Figure 9 is a circuit diagram of said oscillator of the previous figure.
Figure 10 shows the block diagram of the upper hierarchical level of the binary counter of the circuit of the invention.
Figure 11 depicts a block diagram of a following hierarchical level of said binary counter of the previous figure.
Figure 12 is a block diagram of one of the blocks BUCB of the previous figure.
Figure 13 shows the block diagram of the upper hierarchical level of the parallel-to-serial converter of the circuit of the invention.
Figure 14 depicts a block diagram of a following hierarchical level of the converter of the previous figure.
Figure 15 is a block diagram of the block PBUCPS of the previous figure.
Figure 16 is a block diagram of one of the blocks BUCPS of Figure 14.
Figure 17 depicts the process of calibration and possible sending of the reference value together with the measurement made to a monitor.
Figure 18 is a circuit diagram of the pulse generator of the ring oscillator incorporating a circuit for protecting against variations of the power supply.

### Detailed Description of the Invention

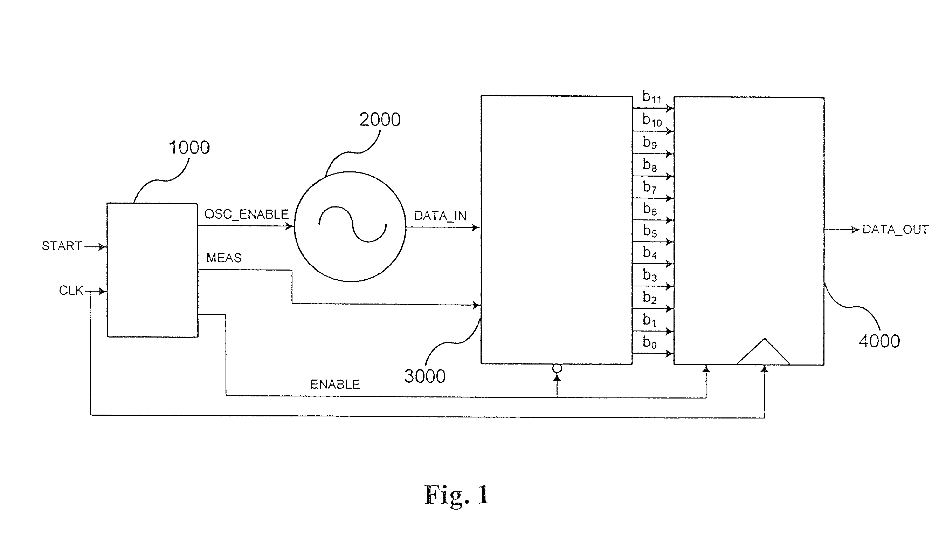

The object of the invention relates to a low consumption, digital output capacity-frequency converter circuit for capacitive transducers which, as shown in the diagram of Figure 1, comprises a control logic block (1000), a ring oscillator (2000) dependent on the magnitude to be measured, a binary counter (3000) and, optionally, a parallel-to-serial converter (4000).

The circuit has two inputs "START" and "CLK", the first of which is a step signal used to start the measurement process of the circuit, such that the start-up of the circuit occurs with the rising flank of said signal "START", while the signal "CLK" is a clock signal necessary for generating control logic signals and the correct operation of the block (4000), this clock signal being thermally independent, i.e., the frequency thereof does not vary with temperature. The output signal of the circuit is in turn given by a signal "DATA_OUT", which is the digital serial depiction of the measurement that is obtained (for example in the form of a 12-bit word).

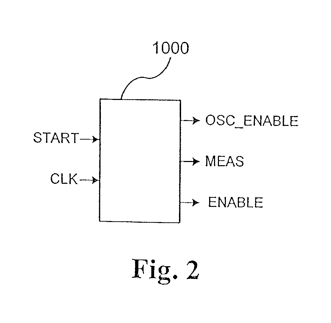

The control logic block (1000), which is independently depicted in Figure 2, is in charge of generating the digital signals (pulses in "1" for a certain time) necessary for the correct coordination of the rest of the components of the circuit, said signals being "OSC_ENABLE", "MEAS" and "ENABLE".

The signal "OSC_ENABLE" controls the start (with its rising flank) and the end (with its falling flank), of the operation of the ring oscillator (2000), such that the width of this pulse determines the time during which the ring oscillator (2000) generates a pulse train at its output.

The width of the signal "MEAS" in turn determines the time during which the pulses delivered by the output pulse train of the ring oscillator (2000) are counted in the binary counter (3000) and additionally, the pulse of said signal "MEAS" is contained (it has a smaller width) in the pulse of the signal "OSC_ENABLE", whereby preventing counting pulses in the start and in the end of the pulse train (start-up and stop of the oscillator), which are transitory regions affecting the oscillation frequency of the pulse train.

The width of the pulse of the signal "ENABLE" finally defines the time during which the circuit operates from when the measurement process starts until the binary counter (3000) delivers a word in parallel as a digital representation of the measurement.

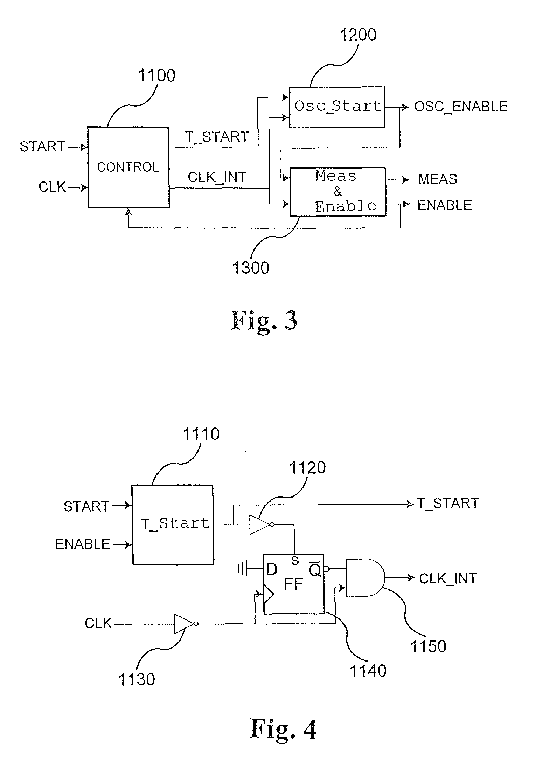

A possible internal embodiment of the control logic block (1000) is depicted in Figure 3, comprising a control block (1100), a block "Osc_Start" (1200) and a block "Meas_&_Enable" (1300).

The control block (1100) generates two modified versions "T_START" and "CLK_INT" of the input signals "START" and "CLK", respectively, which are useful as input for blocks (1200) and (1300).

The block "Osc_Start" (1200) generates the output signal "OSC_Enable", which in turn is useful as input for the block "Meas_&_Enable" (1300), while the latter generates the output signals "MEAS" and "ENABLE", the latter being useful as an input signal, in turn, for the control block (1100).

Figure 4 shows the content of the control block (1100), in which the modified version "T_START" of the signal "START" is generated in the block "T_Start" (1110), while the rest of the components, inverters (1120) and (1130), flip-flop (1140) and AND logic gate (1150), are used to generate the internal clock signal "CLK_INT", from the general clock signal "CLK", with the aid of the signal "T_START".

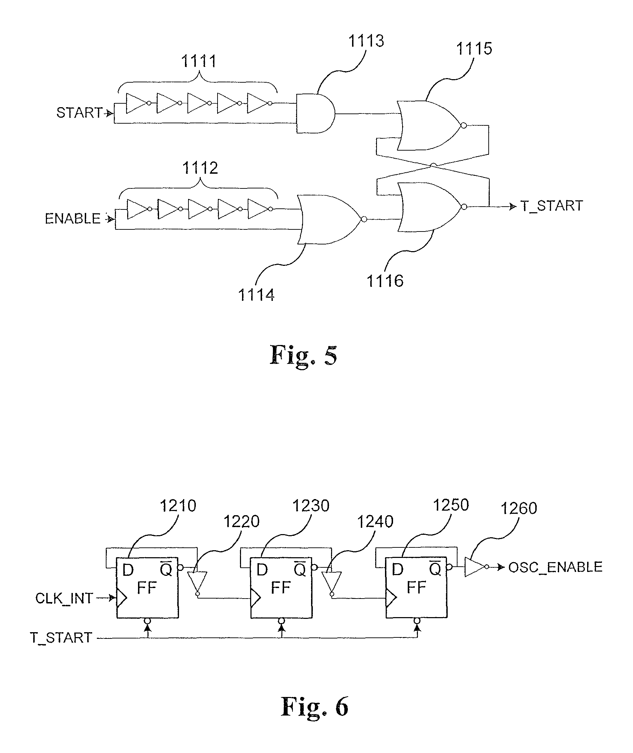

Figure 5 shows the content of the block "T_Start" (1110), which generates the signal "T_START" from the input signals "START" and "ENABLE", and is formed by respective chains of five inverters (1111) and (1112), an AND logic gate (1113) and three NOR logic gates (1114), (1115) and (1116).

Figure 6 shows the inside of the block "Osc_Start" (1200), which generates the control signal "OSC_ENABLE" for the oscillator (2000), from the input signals "CLK_INT" and "T_START", being formed by three flip-flops (1210), (1230) and (1250), and by three inverters (1220), (1240) and (1260).

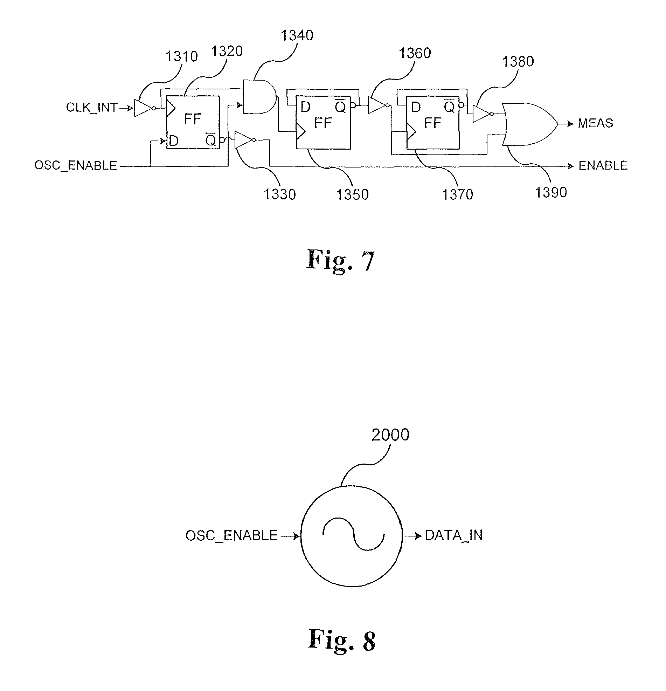

Figure 7 shows the content of the block "Meas_&_Enable" (1300), which generates the control signal "MEAS" necessary for the binary counter (3000), and the "ENABLE" signal required both by said binary counter (3000) and by the parallel-to-serial converter (4000), from the input signals "CLK_INT" and "OSC_ENABLE", this block (1300) being formed by four inverters (1310), (1330), (1360) and (1380), three flip-flops (1320), (1350) and (1370), an AND logic gate (1340) and an OR logic gate (1390).

Figure 8 shows the ring oscillator (2000) dependent on the magnitude to be measured, in which the input "OSC_ENABLE", from the control logic block (1000), controls the time during which this ring oscillator (2000) remains active, while the output "DATA_IN" represents the pulse train the oscillation frequency of which is a function of the delay introduced by the logic gates and by the inserted capacitor or capacitors forming it, said delay in turn being a function of the temperature, due to the thermal dependence the logic gates have, and is also a function of the magnitude to be measured, due to the dependence that variable capacitors have with said magnitude.

To that end certain thermal compensation is required so that the oscillation frequency of the output pulse train depends only on the magnitude to be measured and does not depend (or depends to the smallest possible extent) on temperature, the pulse train existing while the ring oscillator (2000) remains in the active state.

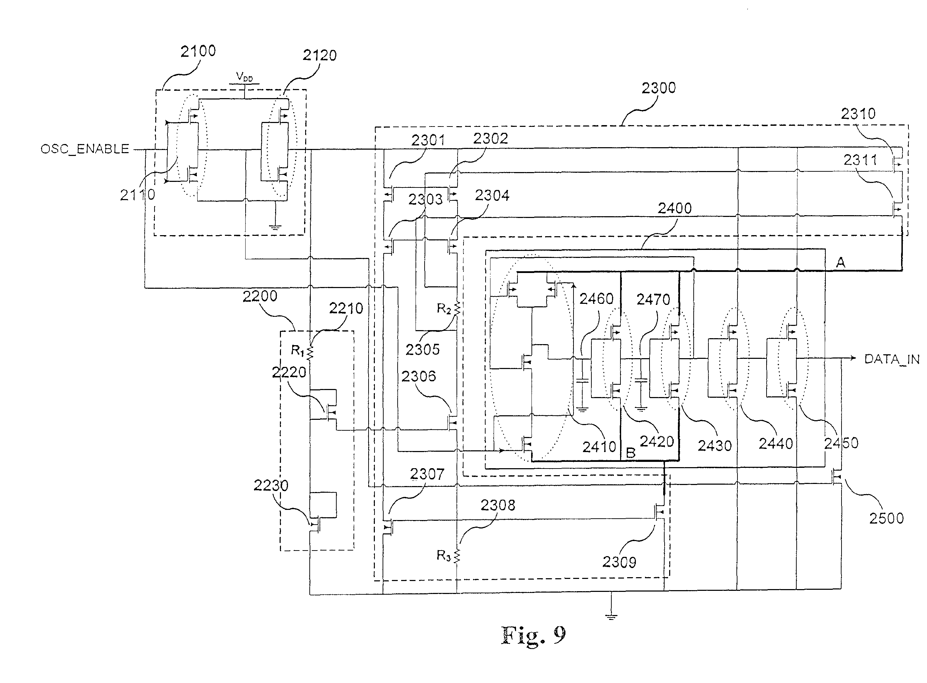

The circuitry of the ring oscillator (2000), depicted in Figure 9, consists of an assembly comprising a circuit (2100), a circuit (2200), a circuit (2300) and a circuit (2400).

The object of the circuit (2100) is to activate/deactivate the supply voltage V_{DD} for the rest of the circuits of the ring oscillator (2000), i.e., while the signal "OSC_ENABLE" remains in logic state "1", the two inverters (2110) and (2120) connect the supply V_{DD} with the output node of the circuit (2100), whereby reducing the consumption of the circuit, because the circuit only consumes power while the signal "OSC_ENABLE" is in state "1".

The circuit (2200) is used to establish a stable operating point for the circuit (2300) which is a current source, and consists of a resistor R₁ (2210) and two NMOS transistors (2220) and (2230).

The current source (2300) is used to supply the circuit (2400), this current source (2300) being especially designed to have a high power supply rejection ratio (PSRR), with which it is intended to make the oscillation generator circuit (2400) as free as possible of fluctuations in the supply voltage, since said fluctuations affect the generated oscillation frequency.

Said current source (2300) is made up of PMOS transistors (2301, 2302, 2303, 2304, 2310 and 2311), NMOS transistors (2306, 2307 and 2309) and resistors R₂ (2305) and R₃ (2308).

The pulse generator circuit (2400) is the core of the entire ring oscillator (2000), comprising an odd number of closed-loop negation logic gates, which are the NAND gate (2410) and the inverters (2420, 2430,2440 and 2450).

The variable capacitors (2460 and 2470) are in turn the core of the capacitive transducer to which the capacity/frequency converter circuit is applied, each of these capacitors being designed so that its capacity value varies with the magnitude to be measured, and since said capacitors are inserted between the logic gates, they introduce a delay (which is added to the delay introduced by the logic gates) dependent on their capacity values, with which an output oscillation frequency "DATA_IN" which is a function of the magnitude to be measured is obtained.

In addition, the delay introduced by the logic gates inherently depends on the temperature, such that a higher temperature decreases the mobility of electrons and gaps in the transistors which form the logic gates, whereby increasing the delay introduced by the gates, for which reason the circuit must be compensated in temperature, so that the final measurement depends almost exclusively on the magnitude object of the measure, or in other words, so that the distortion in the measurement introduced by the thermal effect is as low as possible.

By way of example, the thermal compensation is carried out by adjusting the resistors and the channel widths and lengths of the transistors forming the circuits (2300) and (2400), until the output oscillation frequency is insensitive enough with the temperature so as to distinguish two adjacent oscillation frequencies corresponding to two adjacent values of the magnitude to be measured. Said values are given by the resolution that is desired for the transducer.

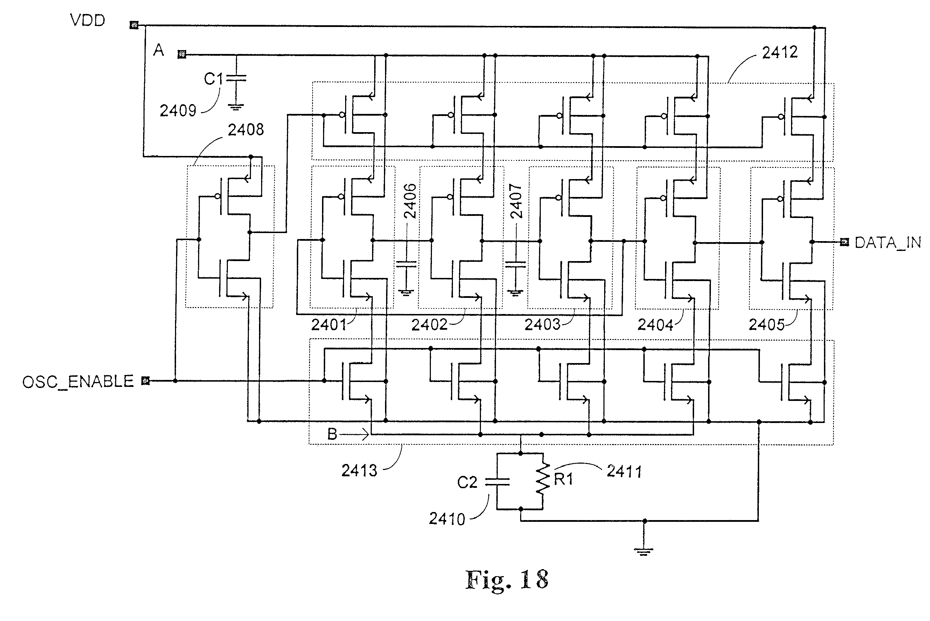

Figure 18 shows another possible embodiment of the pulse generator circuit (2400) of the ring oscillatory (2000) providing a greater PSRR factor to manage to desensitize the frequency of the oscillator to the variations of the supply voltage.

By way of example, the pulse generator is formed by an inverter (2408), PMOS transistors (2412), NMOS transistors (2413), capacitors C1 and C2 (2409 and 2410), a resistor R1 (2411), inverters (2401 to 2405) and capacitors dependent on the magnitude to be measured (2406 and 2407).

As previously indicated, the signal "OSC_ENABLE" is used to activate/deactivate the rest of the circuit. To that end, the inverter (2408) controls the gate terminals of the PMOS transistors (2412) and the NMOS transistors (2413), such that when "OSC_ENABLE" has a logic level "0" (deactivated), the terminals receive a logic signal "1" and the transistors (2412 and 2413) switch to a non-conducting condition.

Since the ring oscillator does not receive voltage in the transistors (2412 and 2413), it will not be supplied and the entire circuit will be deactivated.

In addition, when the signal "OSC_ENABLE" determines a logic value "1", the transistors (2412 and 2413) will be conducting and the circuit of the ring oscillatory will be supplied and therefore activated.

The supply for the ring oscillator is performed through node "A" from the current source (2300). To maximally reduce the fluctuations of the voltage in said node "A", a capacitor "C1" (2409) is incorporated, acting as a filter absorbing said fluctuations.

The core of the ring oscillator is formed by the inverters (2401 to 2405) and the capacitors dependent on the magnitude to be measured (2406 and 2407), the PMOS transistors (2412) being incorporated on this core and the NMOS transistors (2413) just under it, jointly forming a cascode conferring it with independence with respect to the variations in the supply voltage.

To help the inverters (2401 to 2405) in the switching operation, a resistor "R1" (2411) is incorporated in parallel in a capacitor "C2" (2410) which increase the minimum voltage of the inverters, making the difference between the minimum and maximum voltage thereof be smaller.

At the output of this embodiment of the pulse generator circuit (2400) of the ring oscillator, the signal "DATA_IN", which will be a pulse train the dependence of which on the supply voltage will be minimal in contrast with its dependence on the magnitude to be measured, which will be high, is obtained at the output terminal.

The NMOS transistor (2500) allows maintaining the output "DATA_IN" in a defined logic state "0" when the signal "OSC_ENABLE" is worth "0" and therefore the oscillator (2000) is deactivated; in other words, when the signal "OSC_ENABLE" is worth "0", the gate to source voltage V_{GS} of the transistor (2500) is worth V_{DD} and said transistor enters into saturation by grounding the node "DATA_IN". In contrast, when "OSC_ENABLE" is worth "1" and the oscillator (2000) is therefore active, the voltage V_{GS} of the transistor (2500) will be null and it will be in open circuit, the output "DATA_IN" not interfering in any way.

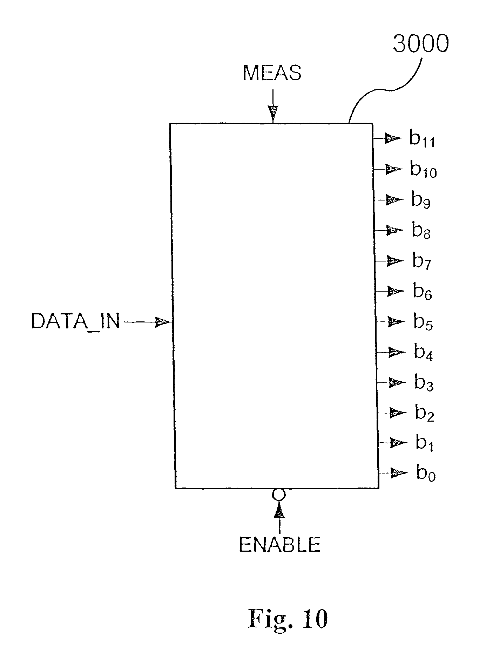

The purpose of the binary counter (3000), depicted in Figure 10, is to take the pulse train delivered by the ring oscillator (2000) in the input "DATA_IN" and counting the number of pulses in the fixed time marked by the input "MEAS", such that when the measurement process ends and the input signal "ENABLE" is again worth "0", the counter (3000) restarts (its count is set to 0) and is ready for the following measurement. The count, in binary representation, of the counter (3000) when the measurement process ends is delivered to the output, which in the example considered consists of 12 pins, from "b₁₁" (which is the most significant bit), to "bₒ" (which is the least significant bit).

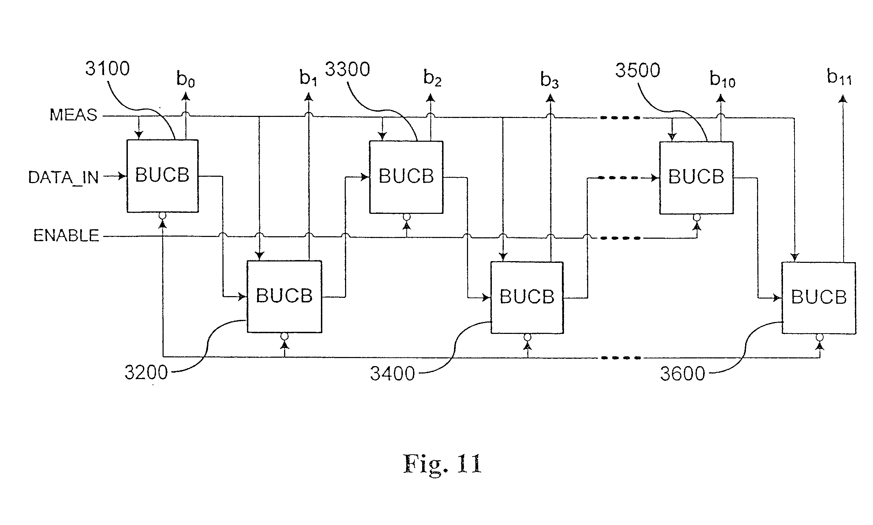

Said binary counter (3000) is formed (Figure 11) by twelve identical BUCB (Binary Unitary Counter Block) (3100 to 3600), each of which takes the signals "MEAS", "ENABLE" and the output of the previous block to deliver one of the twelve bits of the binary count as output.

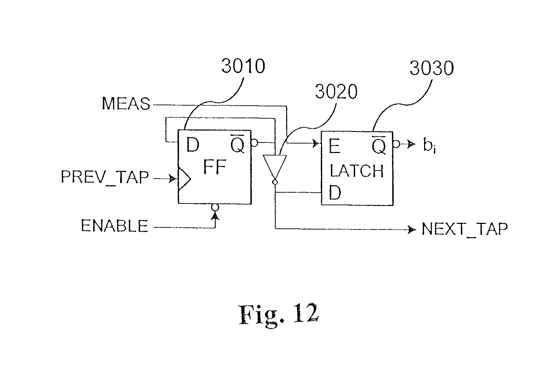

Each of the blocks BUCB consists of (Figure 12) a flip-flop (3010), an inverter (3020) and a latch (3030), providing as inputs the signals "MEAS" and "ENABLE" and the output "PREV_TAP" of the previous block, and as outputs the i-th bit "bᵢ" and input "NEXT_TAP" for the following block.

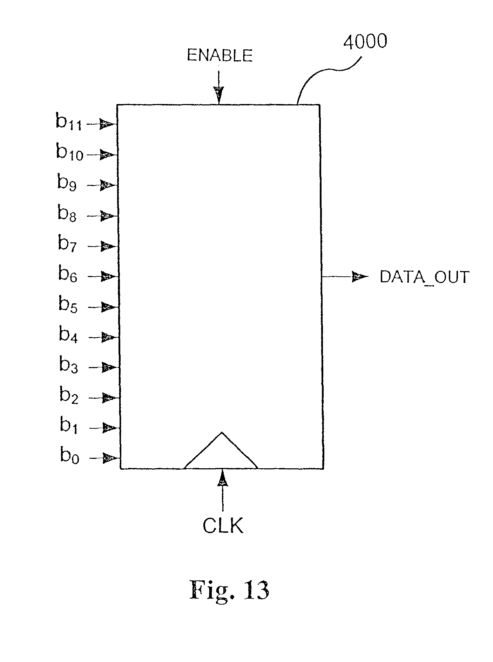

The parallel-to-serial converter (4000), depicted in Figure 13, gets in series at the output "DATA_OUT", at the rhythm imposed by the clock signal "CLK" of the circuit, the binary representation in parallel of the temperature measurement loaded in the inputs from "b₁₁" to "bₒ", such that in order to correctly read the twelve-bit serial word in the output "DATA_OUT", it is necessary to consider "bᵢ" when the input signal "ENABLE" drops to "0", and from that instant it will read one bit in each cycle of the clock signal. Therefore the twelve-bit word, arranged from the most significant bit "b₁₁" to the least significant "bₒ", is obtained in twelve consecutive cycles of the clock signal "CLK".

Having the parallel-to-serial converter (4000) in the circuit, even though it is optional, facilitates possible measurements and testing thereof since it has all the information relating to the measurement in a single output terminal.

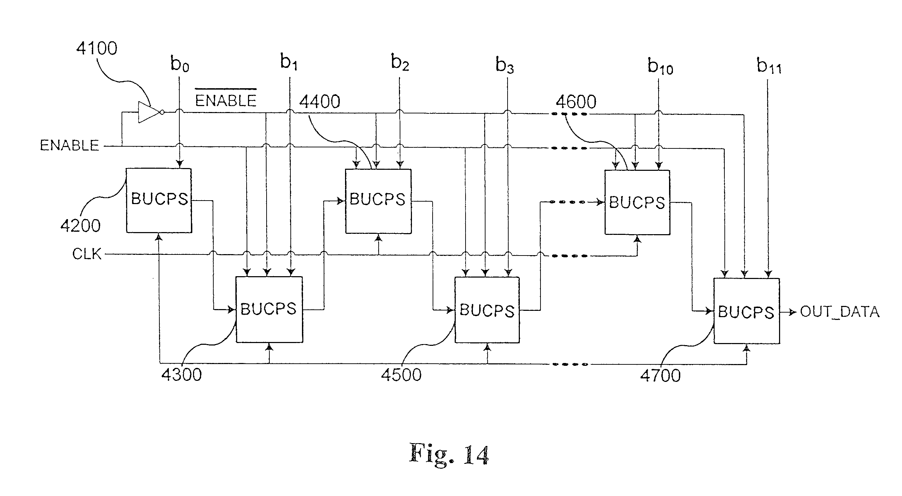

A possible embodiment of said parallel-to-serial converter (4000) consists of (Figure 14) an inverter (4100), a block PBUCPS (4200), which is the first unitary parallel-to-serial converter block, and eleven remaining blocks BUCPS (4300 a 4700), all the blocks, except the first one, taking as input the signals "ENABLE", "CLK", the i-th bit "bᵢ" and the output of the previous block, to generate as output the input of the following block, until the latter delivers the word "OUT_DATA".

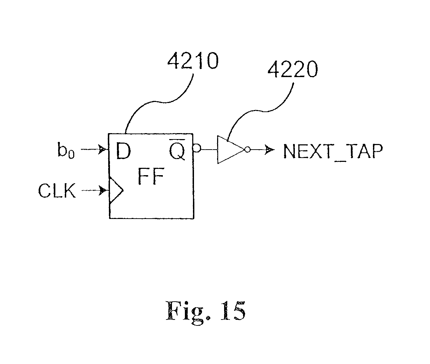

The inside of the block PBUCPS (4200) is formed by (Figure 15) a flip-flop (4210) and an inverter (4220), the clock signal "CLK" and the least significant bit "bₒ" acting as inputs, whereas the output "NEXT_TAP" is the input for the following BUCPS.

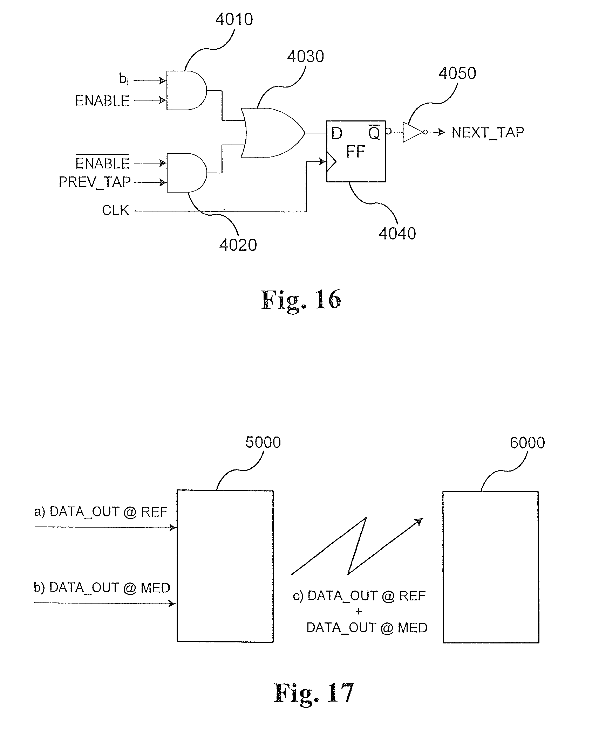

As a possible embodiment (Figure 16) each of the blocks BUCPS consists of two logic gates (4010) and (4020), an OR gate (4030), a flip-flop (4040) and an inverter (4050), each of these BUCPS generating the output "NEXT_TAP" which is the input of the following block, until the latter delivers at its output "NEXT_TAP" the final representation of the measurement "DATA_OUT".

Figure 17 depicts a possible process of calibrating the proposed circuit, which consists of the steps: a) the measurement process for a known value of the magnitude to be measured and valid as a reference is carried out once, its digital representation in twelve bits "DATA_OUT@REF" being obtained in the output "DATA_OUT", and this twelve-bit word is saved in a register or memory of the circuit; b) the same process is carried out for the value of the magnitude to be measured, resulting in a word "DATA_OUT@MED", which is also stored in the register; c) finally both digital representations are provided as outputs. From then, the possible monitor (reader or receiver) (6000) has a reference value "DATA_OUT@REF", with which the value of the magnitude measurement of the future words "DATA_OUT@MED" it receives are compared and deducted, such that the entire computational load is left for the monitor, thus simplifying the logic of the transducer.

## Claims

1. A capacity-frequency converter circuit for capacitive transducers, **characterized in that** it consists of a binary counter (3000) and a ring oscillator (2000) provided with variable capacity capacitors with the magnitude to be measured, inserted between negation logic gates, such that the frequency of said ring oscillator (2000) is dependent on that capacity, the binary counter (3000) providing a binary digital output that is a function of the mentioned frequency of the ring oscillator (2000) and therefore of the magnitude to be measured.

2. The capacity-frequency converter circuit for capacitive transducers according to claim 1, **characterized in that** the ring oscillator (2000) is formed by:
a) An activation and deactivation circuit for activating and deactivating the supply voltage for the rest of the components integrating the oscillator.
b) A current source for supplying to the oscillator.
c) A start-up circuit for the current source which supplies the oscillator.
d) A pulse generator formed by an odd number of negation logic gates.
e) One or several capacitors inserted between the negation logic gates, the capacity values of which vary with the magnitude to be measured.

3. The capacity-frequency converter circuit for capacitive transducers according to claim 2, **characterized in that** the pulse generator of the ring oscillator (2000) is formed by any one combination of logic gates to obtain at the output a pulse train the oscillation frequency of which is a function of the delay introduced by the logic gates and the capacitors inserted between them.

4. The capacity-frequency converter circuit for capacitive transducers according to claim 1, **characterized in that** it incorporates an RFID transponder as part of a capacitive transducer communicated with an RFID receiver or reader.

5. The capacity-frequency converter circuit for capacitive transducers according to claims 1 and 2, **characterized in that** the pulse generator of the ring oscillator (2000) incorporates a mechanism for protecting against variations in the supply voltage formed by:
a) capacitors to filter the fluctuations at the supply points of the oscillator
b) transistor assemblies located on and under the transistors of the pulse generator of the oscillator forming a cascode structure.
